# EUROPEAN PATENT APPLICATION

(11) **EP 4 579 743 A1**
(43) Date of publication of application: **02.07.2025**
(21) Application number: 23307397.2
(22) Date of filing: 27.12.2023
(51) Int. Cl.: H01L 23/66, H03F 1/02, H03F 3/195, H03F 3/213, H03F 3/24

(54) **MULTIPLE-PATH POWER AMPLIFIER WITH CAPACITOR FOR COMPENSATING FOR A COUPLING BETWEEN AMPLIFIER PATHS**

(71) Applicant: NXP USA, Inc., Austin TX 78735 (US)
(72) Inventor: Scatamacchia, Damien, 31023 Toulouse (FR); Bollinger, Laure, 31023 Toulouse (FR)
(74) Representative: Hardingham, Christopher Mark

(57) **Abstract**

Aspects of this disclosure are directed to various circuit topologies for mitigating coupling. In some embodiments, an amplifier circuit is provided that includes a first amplifier path, a second amplifier path, and a capacitor. The first amplifier path may include a first input, a first transistor, and a first wire coupled between the first input and a first terminal of the first transistor. The second amplifier path may include a second input, a second transistor, and a second wire coupled between the second input and a first terminal of the second transistor. The capacitor may include a first terminal coupled to the first input and a second terminal coupled to the second input. Under such an arrangement, the capacitor may be configured to compensate for a coupling between the first wire and the second wire. Other embodiments are disclosed.

## Description

### FIELD OF THE DISCLOSURE

This present disclosure relates, in general, to multiple-path amplifiers, and in particular to compensating for coupling between amplifiers of a multiple-path power amplifier component.

### BACKGROUND

Designing power amplifiers is challenging, even for experienced engineers. Increasingly, components of a power amplifier are taking on even smaller dimensions or form factors, applications where a power amplifier is used are being designed or modified to include additional functionality/features, a target device where a power amplifier is deployed is also generally decreasing in size, and operating speeds or frequencies are increasing. Taken individually and in the aggregate, the aforementioned factors tend to reduce an amount of isolation (e.g., electrical isolation, physical space/distance, thermal isolation) between the components of the power amplifier, leading to an increase in a coupling (e.g., a parasitic coupling) between the components. The increase in coupling is frequently accompanied by a degradation in performance (in terms of efficiency, peak power, linearizability, etc.).

For many power amplifiers, studies and investigations have indicated that the impact of the coupling is most pronounced in terms of an inductive coupling (e.g., mutual inductance) involving wires/leads of components (e.g., transistors). Accordingly, techniques for compensating for the coupling may yield improvements in performance.

### BRIEF DESCRIPTION OF THE DRAWINGS

Reference will now be made to the accompanying drawings, which are not necessarily drawn to scale, and wherein:
FIG. 1 illustrates a schematic diagram of a multiple-path power amplifier in accordance with aspects of this disclosure.
FIGS. 2, 3, and 4 illustrate diagrams of multiple-path power amplifiers incorporating a capacitor for compensating for coupling in accordance with aspects of this disclosure.
FIG. 5 illustrates a capacitor in accordance with aspects of this disclosure.
FIG. 6 illustrates parameters of the capacitor of FIG. 5 in accordance with aspects of this disclosure.
FIG. 7 illustrates a diagram of a circuit incorporating aspects of this disclosure.
FIG. 8 illustrates a plot/graph of a value of a capacitor relative to operating frequency in accordance with aspects of this disclosure.
FIG. 9 illustrates a flowchart of an exemplary method in accordance with aspects of this disclosure.

### DETAILED DESCRIPTION

The subject disclosure describes, among other things, illustrative embodiments for compensating for coupling (e.g., parasitic or inductive coupling) between paths of a multiple-path power amplifier circuit.

One or more of the exemplary embodiments may include, in whole or in part, a first amplifier path that includes a first input, a first transistor, and a first wire coupled between the first input and a first terminal of the first transistor, a second amplifier path that includes a second input, a second transistor, and a second wire coupled between the second input and a first terminal of the second transistor, and a planar capacitor with a first terminal coupled to the first input and a second terminal coupled to the second input, wherein the planar capacitor is configured to compensate for a coupling between the first wire and the second wire.

One or more of the exemplary embodiments may include, in whole or in part, a first amplifier path that includes a first output, a first transistor, and a first wire coupled between the first output and a first terminal of the first transistor, a second amplifier path that includes a second output, a second transistor, and a second wire coupled between the second output and a first terminal of the second transistor, and a capacitor with a first terminal coupled to the first output and a second terminal coupled to the second output, wherein the capacitor is configured to compensate for a coupling between the first wire and the second wire.

One or more of the exemplary embodiments may include, in whole or in part, a radio frequency (RF) input node, a RF output node, a power splitter configured to split an input RF signal received at the RF input node and divide power of the input RF signal into a carrier portion of the input RF signal and a peaking portion of the input RF signal, wherein the carrier portion traverses a first path that includes a first transistor and the peaking portion traverses a second path that includes a second transistor, and a first capacitor with a first terminal coupled to the first path and a second terminal coupled to the second path, the first capacitor compensating for parasitic coupling between first wirebonds of the first path and second wirebonds of the second path.

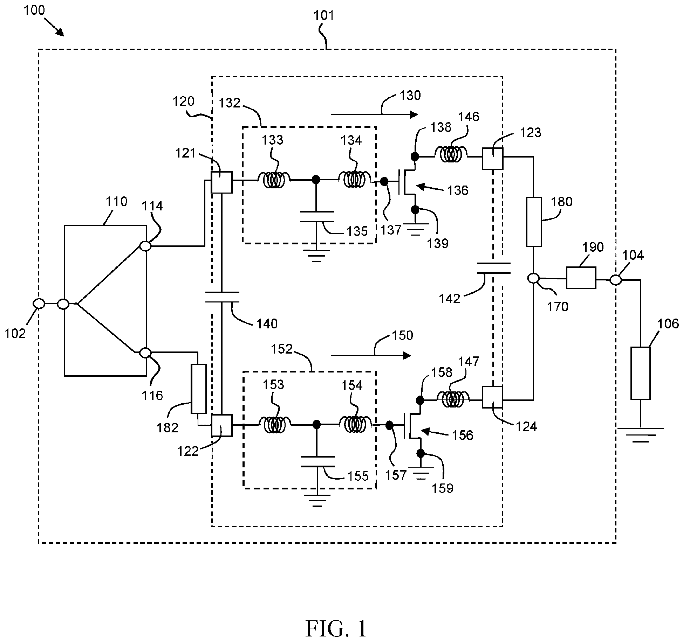

FIG. 1 illustrates a simplified diagram of an embodiment of a multiple-path power amplifier 100. More particularly, FIG. 1 is a schematic depiction of a Doherty power amplifier 100, although embodiments of the inventive subject matter may be implemented in other types of multiple-path power amplifiers (e.g., push-pull amplifiers, balanced amplifiers, 2-up (in phase) power amplifiers, and other types of amplifiers), as well. The description of the inventive embodiments in the context of a Doherty power amplifier is meant to provide a concrete example, and not to limit application of the inventive embodiments only to Doherty amplifiers.

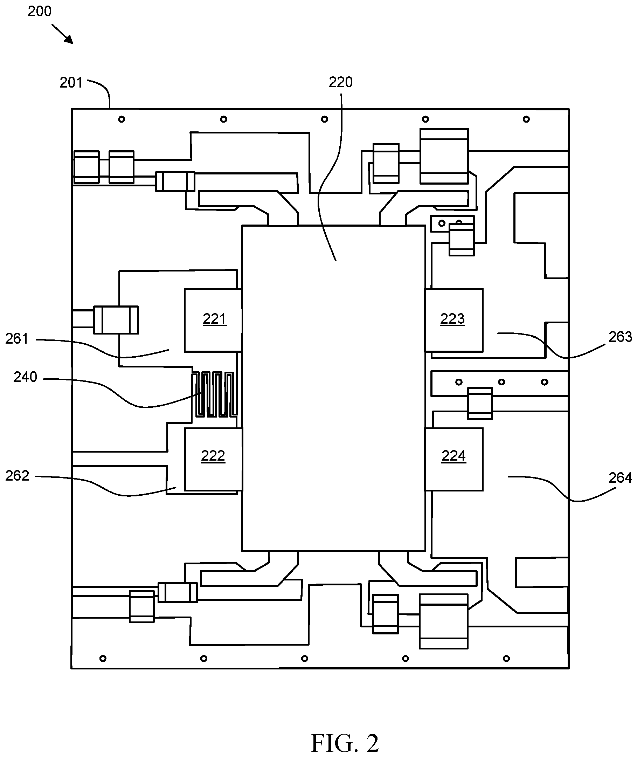

The Doherty power amplifier 100 may be supported by a substrate 101, such as a printed circuit board (PCB) (e.g., PCB 201, 301, 401, FIGs 2-4). In addition, various components of the Doherty power amplifier 100 may be housed in a packaged semiconductor device 120 (e.g., device 220, 320, 420, FIGs 2-4), which may be mounted on the substrate 101.

According to one or more embodiments, Doherty amplifier 100 includes an RF input node 102 (e.g., a first coaxial RF connector), an RF output node 104 (e.g., a second coaxial RF connector), a signal splitter 110, a carrier amplification path 130 (generally, a "first amplification path"), a peaking amplification path 150 (generally, a "second amplification path"), a combining node 170, and an output impedance transformer 190, in an embodiment. Doherty power amplifier 100 is considered to be a "two-way" Doherty power amplifier, which includes one carrier amplification path 130 and one peaking amplification path 150. In other embodiments, more than one peaking amplification path may be implemented in parallel with the first peaking amplification path 150 to produce an N-way Doherty power amplifier, where N>2.

When incorporated into a larger RF system, the RF input node 102 is coupled to an RF signal source (not shown), and the RF output node 104 is coupled to a load 106 (e.g., an antenna or other load). The RF signal source provides an input RF signal, which is an analog signal that includes spectral energy that typically is centered around one or more carrier frequencies. Fundamentally, the Doherty amplifier 100 is configured to amplify the input RF signal, and to produce an amplified RF signal at the RF output node 104.

According to an embodiment, power splitter 110 may be implemented on the substrate 101. Power splitter 110 is configured to receive the input RF signal from node 102, and to divide the power of the input RF signal into carrier and peaking portions of the input signal. The carrier input RF signal is provided to the carrier amplification path 130 at power splitter output 114, and the peaking input RF signal is provided to the peaking amplification path 150 at power splitter output 116. During operation in a low-power mode when only the carrier amplification path 130 is supplying current to the load 106, the power splitter 110 provides the input signal power only to the carrier amplification path 130. During operation in a full-power mode when both the carrier and peaking amplification paths 130, 150 are supplying current to the load 106, the power splitter 110 divides the input signal power between the amplification paths 130, 150.

Power splitter 110 may divide the power of the input RF signal equally or unequally, depending on the relative sizes of the below-described carrier and peaking transistors 136, 156. For example, when Doherty amplifier 100 has a symmetric Doherty amplifier configuration in which the carrier and peaking transistors 136, 156 are approximately equal in size (i.e., the Doherty amplifier 100 has a symmetric configuration with a 1:1 carrier-to-peaking size ratio), the power splitter 110 may divide the power such that half of the input signal power is provided to the carrier amplification path 130, and half of the input signal power is provided to the peaking amplification path 150. Conversely, when Doherty amplifier 100 has an asymmetric Doherty amplifier configuration in which the peaking transistor 156 is approximately twice the size of the carrier transistor 136 (i.e., the Doherty amplifier 100 has an asymmetric configuration with a 1:2 carrier-to-peaking size ratio), the power splitter 110 may divide the power such that roughly one third of the input signal power is provided to the carrier amplification path 130, and roughly two thirds of the input signal power is provided to the peaking amplification path 150. In other words, with a 1:2 carrier-to-peaking size ratio, the size of the peaking transistor 156 is about twice the size of the carrier transistor 136, and the power splitter 110 is configured to produce a peaking input signal with about twice the power of the carrier input signal.

Essentially, the power splitter 110 divides an input RF signal supplied at the input node 102, and the divided signals are separately amplified along the carrier and peaking amplification paths 130, 150. The amplified signals are then combined in phase at the combining node 170.

According to one or more embodiments, the carrier amplification path 130 includes a first impedance matching circuit 132, a first power transistor 136 (or multiple series-coupled power transistors), and a phase shift and impedance inversion element 180. The phase shift and impedance inversion element 180 applies about 90 degrees of phase delay to the signal carried along the carrier amplification path 130. For example, the phase shift and impedance inversion element 180 may include a quarter wave transmission line, a lumped-element delay circuit, or another suitable type of delay element or circuit with an electrical length of about 90 degrees.

The peaking amplification path 150 includes an input phase shifter 182, a second impedance matching circuit 152, and a second power transistor 156 (or multiple series-coupled power transistors). It is important that phase coherency between the carrier and peaking amplification paths 130, 150 is maintained across a frequency band of interest (or operational frequency band) to ensure that the amplified carrier and peaking signals arrive in phase at the combining node 170, and thus to ensure proper Doherty amplifier operation. In the Doherty amplifier configuration depicted in FIG. 1 (i.e., a non-inverted Doherty configuration), the input phase shifter 182 applies about 90 degrees of phase delay to the peaking input signal before it is provided to the second power transistor 156. For example, the input phase shifter 182 may include a quarter wave transmission line, a lumped-element delay circuit, or another suitable type of delay element or circuit with an electrical length of about 90 degrees. The phase shift provided by input phase shifter 182 at least partially compensates for output phase shift(s) on the output side of the amplifier, as will be discussed below.

According to an embodiment, the carrier amplification path 130 and the peaking amplification path 150 each include a single-stage amplifier (i.e., an amplifier with a single power transistor 136, 156). In other embodiments, the carrier amplification path 130 and the peaking amplification path 150 each may include multiple power transistors (e.g., a driver transistor and a final stage transistor) connected in a cascade (or series) arrangement.

According to an embodiment, transistors 136, 156 (referred to below as carrier power transistor 136 and peaking power transistor 156) are the primary active components of Doherty power amplifier 100. Each of the transistors 136, 156 includes a control terminal 137, 157, a first current conducting terminal 138, 158, and a second current conducting terminal 139, 159. For example, each transistor 136, 156 may be a field effect transistor (FET), which includes a gate (control terminal 137, 157), a drain (a first current conducting terminal 138, 158), and a source (a second current conducting terminal 139, 159). According to an embodiment, and using nomenclature typically applied to FETs in a non-limiting manner, the gate 137, 157 of each transistor 136, 156 is coupled to the input impedance matching circuit 132, 152, the drain 138, 158 of each transistor 136, 156 is coupled to the combining node 170, and the source 139, 159 of each transistor 136, 156 is coupled to ground (or another voltage reference). Through the variation of control signals provided to the gate of each transistor 136, 156, the current between the current conducting terminals of the transistors 136, 156 may be modulated. According to various embodiments, each of transistors 136, 156 may be a silicon-based transistor (e.g., a laterally diffused metal oxide semiconductor FET), a III-V field effect transistor (e.g., a high electron mobility transistor (HEMT) such as a gallium nitride FET), or another suitable type of transistor.

During operation of Doherty amplifier 100, the carrier power transistor 136 is biased to operate in class AB mode or deep class AB mode, and the peaking power transistor 156 typically is biased to operate in class C mode. In some configurations, the peaking power transistor 156 may be biased to operate in class B or deep class B modes. At low power levels, where the power of the input signal at node 102 is lower than the turn-on threshold level of peaking power transistor 156, the amplifier 100 operates in a low-power mode in which the carrier power transistor 136 is the only power transistor supplying current to the load 106. When the power of the input signal exceeds a threshold level of the peaking power transistor 156, the amplifier 100 operates in a high-power mode in which the carrier power transistor 136 and the peaking power transistor 156 both supply current to the load 106. At this point, the peaking power transistor 156 provides active load modulation at combining node 170, allowing the current of the carrier power transistor 136 to continue to increase linearly.

Doherty amplifier 100 has a "non-inverted" load network configuration. In the non-inverted configuration, the input circuit is configured so that the input signals supplied to the peaking power transistor 156 are delayed by 90 degrees with respect to the input signal supplied to the carrier power transistor 136 at the center frequency of operation of the amplifier 100. The output circuit may be configured so that the output signals supplied by the carrier power transistor 136 are delayed by 90 degrees before being supplied to the combining node 170 in a "90-0" type of Doherty power amplifier. Alternatively, the output circuit may be configured so that the output signals supplied by the carrier power transistor are delayed by 180 degrees and the output signals supplied by the peaking power transistor are delayed by 90 degrees before being supplied to the combining node 170 in a "90-180" type of Doherty power amplifier. Alternate embodiments of Doherty amplifiers may have an "inverted" load network configuration. In such a configuration, the amplifier is configured so that an input phase shifter delays an input signal supplied to the carrier amplifier 136 by about 90 degrees with respect to the input signal supplied to the peaking amplifier 156 at the center frequency of operation of the amplifier 100. The output circuit may be configured so that the output signals supplied by the peaking power transistor 156 are delayed by 90 degrees before being supplied to the combining node 170 in a "90-0" type of Doherty power amplifier. Alternatively, the output circuit may be configured so that the output signals supplied by the peaking power transistor are delayed by 180 degrees and the output signals supplied by the carrier power transistor are delayed by 90 degrees before being supplied to the combining node 170 in a "90-180" type of Doherty power amplifier.

According to one or more embodiments, transistors 136, 156 and impedance matching networks 132, 152 are housed within a discrete, packaged semiconductor device 120 (e.g., device 200, 300 or 400, FIGs 2-4) that is mounted to a surface of the substrate 101. The packaged semiconductor device 120 includes a plurality of terminals 121, 122, 123, 124, which enable electrical communication between circuitry on the substrate 101 and circuitry within the device 120. For example, portions of the carrier amplification path 130 (e.g., impedance matching network 132 and transistor 136) may be housed within device 120, and electrically coupled between a first input terminal 121 (also referred to herein as a "first input") and a first output terminal 123 (also referred to herein as a "first output"), and portions of the peaking amplification path 150 (e.g., impedance matching network 152 and transistor 156) may be housed within device 120, and electrically coupled between a second input terminal 122 (also referred to herein as a "second input") and a second output terminal 124 (also referred to herein as a "second output").

The first and second input impedance matching networks 132, 152 may be implemented, respectively, between a respective input terminal 121, 122 and the control terminal 137, 157 (e.g., gate terminal) of each power transistor 136, 156. In each case, the impedance matching networks 132, 152 may incrementally increase the circuit impedance toward the load impedance. Various types of input impedance matching topologies may be implemented. According to one non-limiting example embodiment, each input impedance matching circuit 132, 152 has a T-match configuration, which includes two inductive elements 133/153, 134/154 and a shunt capacitance 135/155. In each network 132, 152, a first inductive element 133/153 is coupled between an input terminal 121, 122 and a node (not numbered), and a second inductive element 134/154 is coupled between the node and the control terminal 137/157 of a transistor 136/156. The node between the inductive elements may be coupled to a first terminal of a shunt capacitor 135/155, and the second terminal of the shunt capacitor 135/155 may be coupled to ground (or another voltage reference). Each combination of the inductive elements 133/153, 134/154 and the shunt capacitance 135, 155 functions as a low-pass filter. In other embodiments, other types of impedance matching circuits may be used.

Sets of parallel wirebonds (e.g., wirebonds 433, 453, 446, 447) are a convenient way to provide inductances in a radio frequency (RF) circuit, and also are a convenient way to electrically couple the terminals (e.g., terminals 121-124) of a device (e.g., device 120) to the interior electronics (e.g., transistors 136, 156). For example, each of inductive elements 133, 134, 153, 154, 146, 147 may be implemented as a set of wirebonds that is electrically coupled between terminals 121-124 and other components within device 120. At the input side of device 120, inductive elements 133, 153 function as parts of input impedance matching networks 132, 152, while also electrically connecting input terminals 121, 122 to the control terminals 137, 157 of transistors 136, 156. At the output side of device 120, various types of output impedance matching topologies may be implemented. In the non-limiting example of the illustrated embodiment, the output impedance matching topology includes inductive elements 146, 147 that electrically couple the first current-conducting terminals 138, 158 of transistors 136, 156 to the output terminals 123, 124.

It should be pointed out here that RF signals carried by wirebonds may produce electromagnetic radiation, which may result in parasitic coupling that can interfere with signals carried by other sets of wirebonds, proximate electronics, and other conductors. For example, due to their close proximity, each of inductive elements 133/153 (e.g., first and second sets of wirebonds) may produce electromagnetic radiation that parasitically couples with the RF signals carried on those inductive elements 133/153. Similarly, each of inductive elements 134/154 (e.g., third and fourth sets of wirebonds) may experience parasitic inductive coupling, and inductive elements 146, 147 (e.g., fifth and sixth sets of wirebonds) may experience parasitic coupling. This may detrimentally affect performance of the amplifier 100 (e.g., efficiency, peak power, and/or linearizability may be detrimentally affected).

According to one or more embodiments, compensation for such potential parasitic coupling is achieved by connecting one or more capacitors 140 between the carrier and peaking amplification paths 130, 150. In some embodiments, a capacitor 140 is connected between the input terminals 121, 122. In addition or alternatively, one or more capacitors 142 may be connected between the output terminals 123, 124, according to one or more other embodiments. The value of capacitors 140, 142 is relatively small. For example, each capacitor 140, 142 may have a capacitance value in a range of about 0.5 picofarads (pF) to about 1.5 pF, although the capacitance value may be smaller or larger, as well. Desirably, the capacitance value for capacitor 140 and/or 142 is optimized for the fundamental frequency of operation of the amplifier 100. For example, an optimum capacitance value for a fundamental frequency of 1.8 gigahertz (GHz) may be about 0.9 pF.

Desirably, such a capacitor 140 and/or 142 is coupled to the circuit very close to the location where the inductive coupling is taking place to facilitate wideband operation. Further, it is advantageous for the capacitor 140 and/or 142 to have a construction that complies with manufacturing rules (e.g., do not place discrete components around device terminals or terminal pads on a substrate). Embodiments of capacitor 140 and/or 142 (e.g., capacitors 240, 340, 440, FIGs 2, 3, 4) described and shown herein are beneficially configured so that they may be placed very close to a location where inductive coupling may be taking place without using discrete capacitors that may violate design rules. Embodiments of capacitor 140 may be placed on the substrate 101 or within the packaged device 120 between the input terminals 121, 122, or alternatively, embodiments of capacitor 142 may be placed on the substrate 101 or within the packaged device 120 between the output terminals 123, 124.

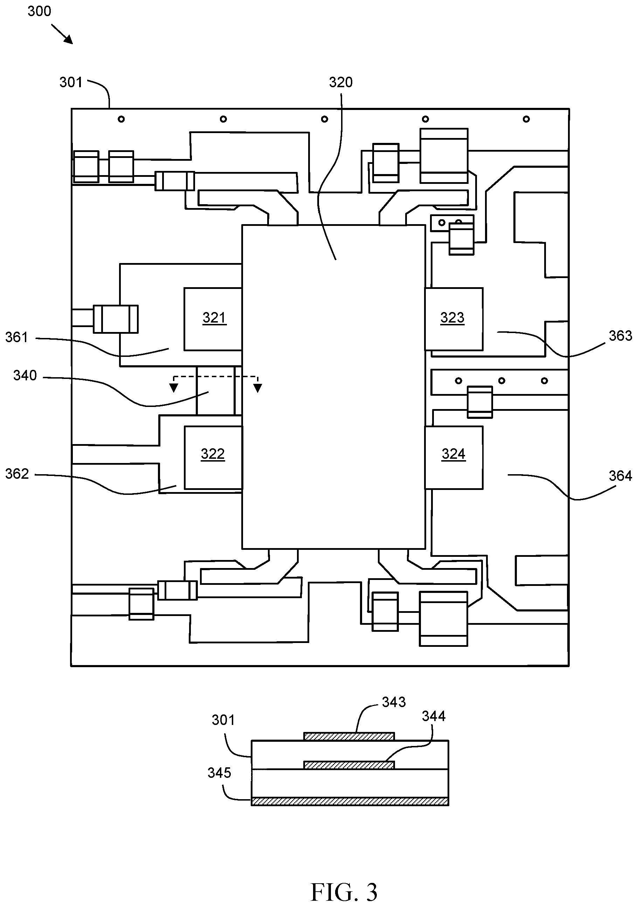

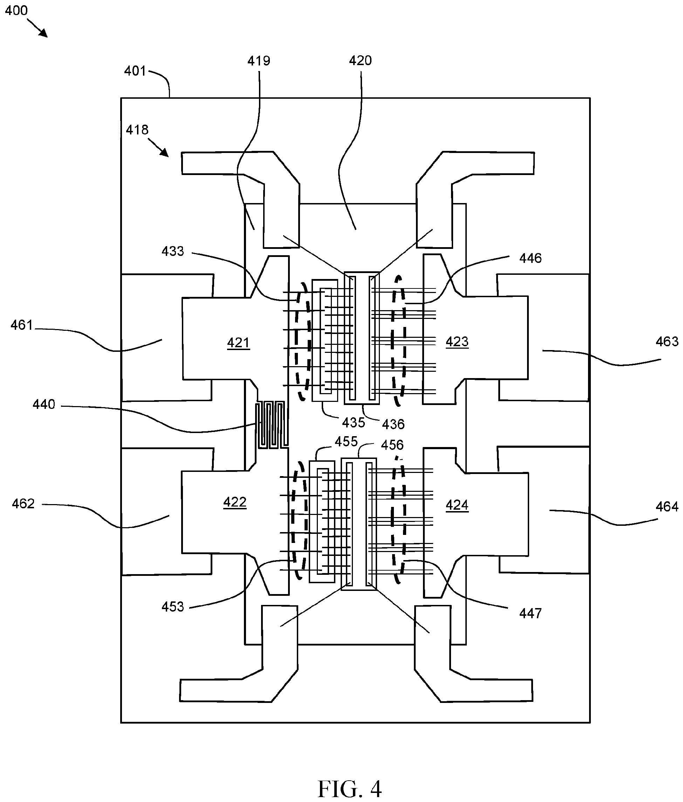

According to some embodiments, capacitor 140 and/or 142 may be coupled to or integrally formed as a part of the substrate 101. In such embodiments, the capacitor 140 may be directly coupled between conductive pads (e.g., between pads 261/262, 361/362, FIGs 2, 3) of the substrate 101 to which the input terminals 121, 122 are connected. Alternatively, if included, capacitor 142 may be directly coupled between conductive pads (e.g., between pads 263/264, 363/364, FIGs 2, 3) of the substrate 101 to which the output terminals 123, 124 are connected. For example, as shown in FIG. 2, capacitor 140 and/or 142 may be a planar capacitor (e.g., capacitor 240) that is formed from interdigitated patterned portions of one of the conductive layers of the substrate 101. Alternatively, as shown in FIG. 3, capacitor 140 and/or 142 may be a parallel plate capacitor (e.g., capacitor 340), which has a first plate formed from a portion of a first conductive layer of the substrate 101, and a second underlying plate formed from a portion of a second conductive layer of the substrate 101. According to some other embodiments, the capacitor 140 and/or 142 may be housed within the packaged semiconductor device 120 and coupled directly between the input terminals 121, 122 or terminals 123, 124. For example, as shown in FIG. 4, capacitor 140 and/or 142 may be a planar capacitor (e.g., capacitor 440) that is formed from interdigitated patterned portions of a leadframe (e.g., leadframe 418).

Referring now to FIGs 2, 3, and 4, diagrams of portions of multiple-path power amplifiers 200, 300, 400 that include embodiments of amplifier 100 are shown. Each amplifier 200, 300, 400 includes, at least, a printed circuit board (PCB) 201, 301, and 401 (or other suitable substrate) and a packaged semiconductor device 220, 320, 420. In addition, although not shown in FIGs 2-4, each power amplifier 200, 300, 400 may include input and output terminals (e.g., terminals 102, 104, FIG. 1), a power splitter (e.g., power splitter 110, FIG. 1), an output impedance inverter and phase shifter (e.g., component 180, FIG. 1), a combining node (e.g., combining node 170, FIG. 1), and an output transformer (e.g., transformer 190, FIG. 1).

Each PCB 201, 301, 401 may be a multiple-layer circuit board with two or more conductive layers separated by one or more dielectric layers. Each PCB 201, 301, 401 includes an upper patterned conductive layer with patterned conductive traces and device mounting pads 261-264, 361-364, 461-464. The input and output terminals 221-224, 321-324, 421-424 (e.g., terminals 121-124, FIG. 1) of each device 220, 320, 420 comprise conductive leads, which are electrically and physically connected (e.g., using solder or conductive adhesive) to the device mounting pads 261-264, 361-364, 461-464 of PCBs 201, 301, 401. Accordingly, devices 220, 320, 420 are surface mounted to the mounting pads of the PCBs 201, 301, 401 using the leads/terminals 221-224, 321-324, 421-424.

The illustrated configurations, respectively, may be used to address (e.g., compensate for) the coupling described above by including capacitors 240, 340, 440 between the input terminals 221/222, 321/322, 421/422 of each device 220, 320, 420.

Referring to FIG. 2, capacitor 240 (e.g., a microstrip interdigital capacitor) is shown as having been formed (e.g., deposited, printed, or etched) on a given conductive plane/layer (e.g., a top or surface layer) of the PCB 201. For example, capacitor 240 may be formed from the same patterned conductive layer as mounting pads 261 and 262. Alternatively, capacitor 240 may be formed from an underlying conductive layer and electrically connected to mounting pads 261, 262 with conductive vias. Either way, capacitor 240 is a "planar" capacitor that includes a first set of capacitor fingers that are directly connected to mounting pad 261, and a second set of capacitor fingers that are directly connected to mounting pad 262 and interdigitated with the first set of capacitor fingers. As indicated above, a similarly-constructed capacitor (e.g., not shown, but corresponding to capacitor 142, FIG. 1) also or alternatively may be included, which has a first set of capacitor fingers that are directly connected to mounting pad 263, and a second set of capacitor fingers that are directly connected to mounting pad 264 and interdigitated with the first set of capacitor fingers.

Referring to FIG. 3, capacitor 340 may be a parallel-plate capacitor formed in the PCB 301. More particularly, as shown in the cross-section at the bottom of FIG. 3, capacitor 340 may be formed from a first capacitor plate 343 (i.e., a portion of a first conductive layer of the PCB 301) and a second capacitor plate 344 (i.e., a portion of an underlying second conductive layer of the PCB 301) which are separated by dielectric material. The PCB 301 also may include a ground layer 345 (e.g., formed from an underlying third conductive layer of the PCB 301). Accordingly, capacitor 340 may traverse multiple planes or layers (e.g., two or more planes or layers) of the PCB 301. For example, the first capacitor plate 343 may be formed from the same patterned conductive layer as mounting pads 361 and 362, and may be directly electrically connected to a first mounting pad 361, and the second capacitor plate 344 may be formed from a portion of an underlying patterned conductive layer, and may be directly electrically connected to a second mounting pad 362. As indicated above, a similarly-constructed capacitor (e.g., not shown, but corresponding to capacitor 142, FIG. 1) also or alternatively may be included, which has a first capacitor plate (not shown) that is formed from the same patterned conductive layer as mounting pads 363 and 364, and may be directly electrically connected to a third mounting pad 363, and the second capacitor plate (not shown) may be formed from a portion of an underlying patterned conductive layer, and may be directly electrically connected to a fourth mounting pad 364.

Referring to FIG. 4, capacitor 440 may be formed from portions of the leadframe 418 for the device 420. According to one or more embodiments, device 420 (e.g., device 120, FIG. 1) may include a substrate 419 to which the electronic components (e.g., transistors 436, 456 and shunt capacitors 435, 455) are coupled. Further, the device 420 may include a leadframe 418 coupled to the substrate 419, which includes the input and output terminals 421, 422, 423, 424 (as well as bias terminals, as shown). According to one or more embodiments, the leadframe 418 also includes capacitor 440 formed between terminals 421 and 422. Similar to capacitor 240 (FIG. 2), capacitor 440 is a "planar" capacitor that includes a first set of capacitor fingers that are directly connected to terminal 421, and a second set of capacitor fingers that are directly connected to terminal 422 and interdigitated with the first set of capacitor fingers. According to one or more other embodiments, the leadframe 418 also or alternatively includes a similarly-constructed, planar capacitor (not shown, but corresponding to capacitor 142, FIG. 1) formed between terminals 423 and 424, and including a first set of capacitor fingers that are directly connected to terminal 423, and a second set of capacitor fingers that are directly connected to terminal 424 and interdigitated with the first set of capacitor fingers. During manufacturing of the device 400, the leadframe 418 may be formed, for example, by stamping a planar conductive sheet of material to form the various terminals 421-424 and capacitor 440 as portions of the leadframe 418. The leadframe 418 is also coupled to the substrate 419, and wirebonds (e.g., wirebonds 433, 453, 446, 447) are connected between the terminals 421-424 and the electronic components (e.g., transistors 436, 456 and shunt capacitors 435, 455).

Each of the solutions for addressing the coupling represented by the amplifiers 200, 300, and 400 may present their own strengths. For example, and relative to a scenario where the techniques of this disclosure are not used, the solution represented by the amplifier 200 may provide between 2 decibels (dB) and 10dB improvement in terms of isolation, with little-to-no development required (and thus, little-to-no extra cost). Further, as described above the capacitor 240 may be placed (e.g., printed) on a surface of the PCB 201, thereby enabling the value of the capacitor 240 to be adjusted (such as during prototyping or testing activities).

Further, the solution represented by the amplifier 300 may provide between 2dB and 10dB improvement in terms of isolation, with little-to-no development required (and thus, little-to-no extra cost). Further, as described above upper plates of the capacitor 340 may be at least partially placed (e.g., printed) on a surface of the PCB 201, thereby enabling the value of the capacitor to be adjusted (such as during prototyping or testing activities).

Further still, the solution represented by the amplifier 400 may provide between 7dB and 10dB improvement in terms of isolation. Further, the solution represented by the amplifier 400 may be more readily produced (relative to a wire fence or other shielding structure) as part of the leadframe and may not impact the design space as much as a wire fence or other shielding structure.

Relative to the amplifier 200 and the amplifier 300, the amplifier 400 might not readily lend itself to an adjustment of the value of the capacitor 440. Thus, if in a given design environment the ability to adjust the capacitor value is desired, the amplifiers 200 and 300 may provide greater flexibility relative to the amplifier 400. Furthermore, the amplifier 400 may require package redevelopment (relative to, e.g., existing or legacy packaging solutions), which may result in additional cost relative to the amplifiers 200, 300 (stated differently, in a cost-conscious environment or application, modifications to the PCBs 201 and 301 may represent a cheaper alternative to modifying the leadframe 418, particularly in terms of up-front cost/investment). Relative to the capacitor 240 in amplifier 200, the capacitor 340 in amplifier 300 may be more complex to fabricate/manufacture due to the presence of the capacitor of the PCB 301 traversing multiple planes/layers.

In brief, and as the foregoing discussion demonstrates, a skilled artisan will appreciate that tradeoffs may be made (in terms of, e.g., the relative strengths and weaknesses/drawbacks amongst the amplifiers 200, 300, 400) to select a particular style/type of PCB or leadframe for use in a given application or environment.

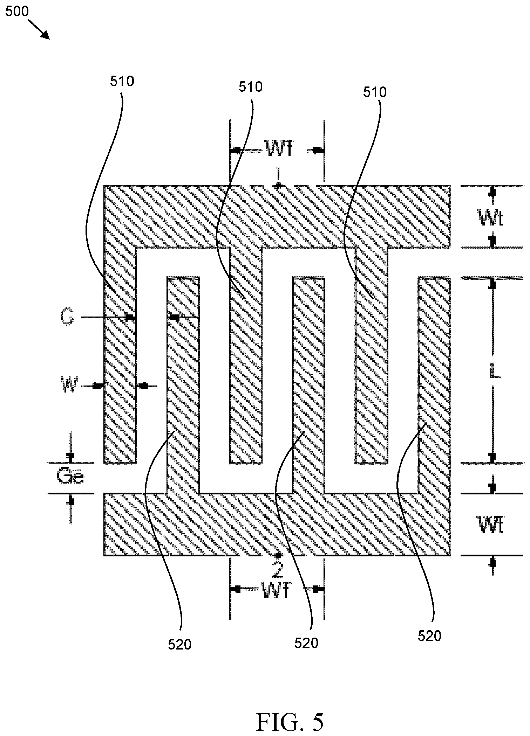

Reference may now be made to FIG. 5, which is a diagram depicting an embodiment of a capacitor 500 (e.g., an interdigitated microstrip capacitor) of this disclosure. For example, any of the capacitors 240, 440 shown in FIGs 2 and 4 may have a configuration such as that of capacitor 500. Capacitor 500 is a "planar" capacitor that includes a first set of capacitor fingers 510 interdigitated with a second set of capacitor fingers 520. As discussed above, the first set of capacitor fingers 510 may be directly connected to a mounting pad (e.g., pad 221, FIG. 2) or to a leadframe terminal (e.g., terminal 421, FIG. 4). Additionally, the second set of capacitor fingers 520 may be directly connected to a mounting pad (e.g., pad 222, FIG. 2) or to a leadframe terminal (e.g., terminal 422, FIG. 4).

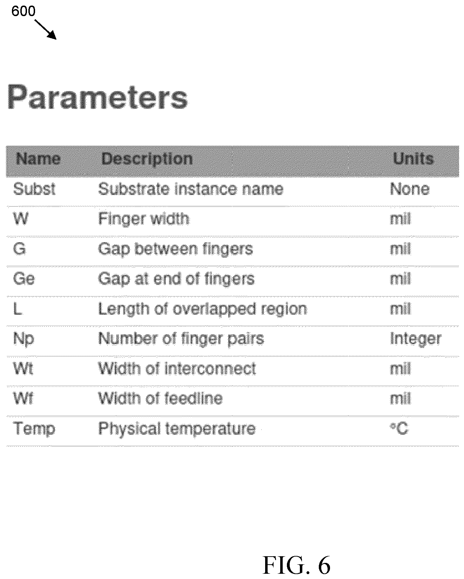

Superimposed in FIG. 5 are parameters W, G, Ge, L, Wt, and Wf. A description of each of these parameters (along with a parameter pertaining to a number of finger pairs - Np - and a parameter pertaining to temperature (Temp)) for a given PCB substrate (Subst) with a default instance name (MSub1) is shown in Table 600 of FIG. 6. Any (default) values included in the Table 600 are illustrative, which is to say that different values for the parameters may be used in a given embodiment or variant of the capacitor 500.

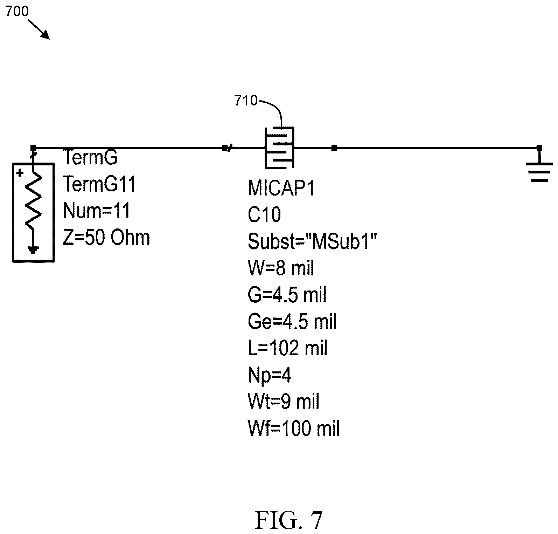

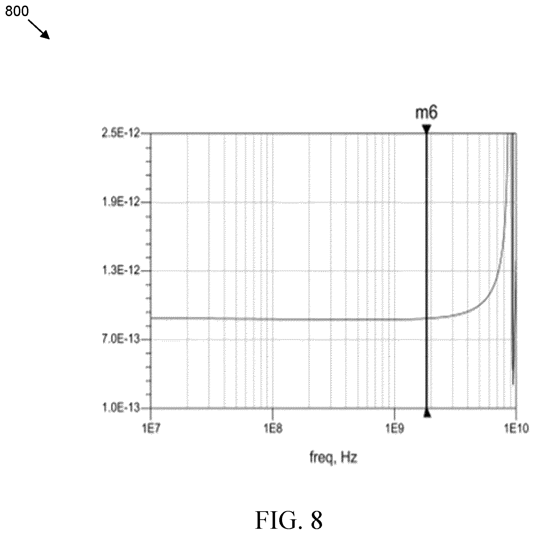

With reference to FIG. 7, a circuit representation 700 incorporating an instance of the capacitor 500 (denoted as MICAP1 710) is shown as existing between a terminating impedance/load Z of 50 Ohms and a reference voltage (e.g., ground). Furthermore, the parameters W, G, Ge, L, Np, Wt, and Wf may, illustratively, assume the values shown in FIG. 7. Referring to FIG. 8, a graph 800 of a value of the capacitor 710 (in Farads) along the vertical axis relative to operating frequency (in Hertz) along the horizontal axis is shown. As shown in FIG. 8, the value of the capacitor may be relatively stable/constant (approximately equal to 0.9 pF) at or below the frequency represented by the line m6 (approximately equal to 2 GHz) superimposed in FIG. 8. Many practical applications involving (the capacitor of) the circuit 700 may tend to utilize operating frequencies that are at or below the frequency represented by the line m6, which is to say that the capacitor of the circuit 700 may be implemented across a relatively wide spectrum or cross-section of circuit or IC/chip designs. Stated differently, except for in rare instances the capacitor of the circuit 700 may only need to be designed or tuned once (in terms of the parameters of the capacitor) and then may readily be deployed across multiple circuits or IC/chip designs with various operating frequencies.

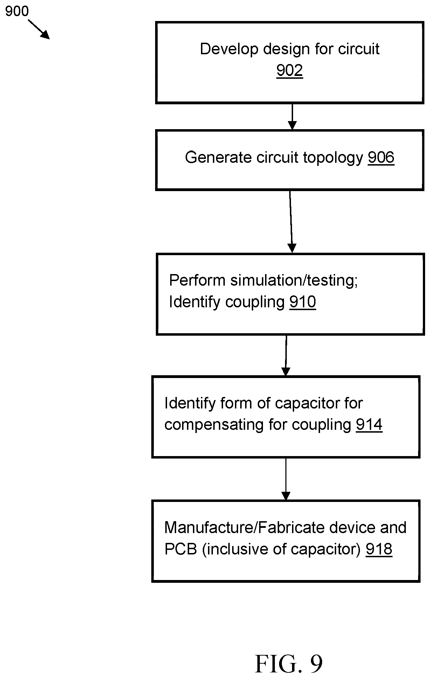

Referring to FIG. 9, a flowchart of a method 900 in accordance with various aspects described herein is shown. The method 900 may be implemented (e.g., executed), in whole or in part, in conjunction with one more systems, devices, and/or components, such as for example the systems, device, and components set forth herein. Aspects of the method 900 may be represented as blocks as shown in FIG. 9. The blocks may correspond to operations that may be facilitated via a use of a processing system that may include one or more processors. The operations may be embodied as instructions (where the instructions may be stored as part of a memory, a computer-readable medium [e.g., a non-transitory computer-readable medium], or the like) that may be executed by the processing system to realize some or all of the functionality/features of the method 900.

In block 902 ("Develop design for circuit"), a design for a circuit may be developed. For example, as part of block 902 a set of features or functions (as potentially represented via requirements, a specification, or the like) that is to be realized may be identified. The set of features or functions may, in turn, result in a circuit design that is to be used.

In block 906 ("Generate circuit topology"), a circuit topology may be generated for the design of block 902. For example, block 906 may include a placement of components within a device (e.g., devices 120, 220, 320, 420), placement of the device on a substrate (e.g., PCB 101, 201, 301, 401), as well as a placement of leads/wires/traces that connect terminals of various ones of components of the circuit design to one another.

In block 910 ("Perform simulation/testing; Identify coupling"), a determination or identification of any potential coupling (e.g., parasitic or inductive coupling) that may exist between the leads/wires/traces of the circuit topology (e.g., between inductances 133/153 and/or 146/147, FIG. 1, or between bondwires 433/453 and/or 446/447, FIG. 4) generated as part of block 906. The determination or identification of block 910 may be facilitated via simulation, testing/prototyping, measurement, or other activities. The determination or identification of block 910 may include or result in a determination or identification of a value of the coupling.

In some embodiments, the operations of the method 900 may terminate at block 910 if, for example, the amount/degree/extent of the coupling that is determined/identified in block 910 is less than a threshold (in this regard, the operations of block 910 may include a comparison of the amount/degree/extent of the coupling to the threshold). For example, it may be the case that a certain amount/degree/extent of coupling is permissible/tolerable in a given practical application or environment, such that it might not be worth the cost (e.g., expense, complexity) to compensate for the coupling. In this respect, the additional blocks/operations of the method 900 described below may assume that the amount/degree/extent of the coupling is greater than the threshold and/or that the nature of the application/environment at hand warrants compensating for the coupling (such as for example in relation to a use of an IC as part of deploying munitions).

In block 914, ("Identify form of capacitor for compensation for coupling") a form or type of capacitor for compensating for the coupling determined/identified in block 910 may be identified/determined/selected. For example, the form or type of the capacitor may correspond to a microstrip capacitor on a top/surface layer of the PCB (see, e.g., FIG. 2 and the corresponding description above), a multi-layer (microstrip substrate) capacitor (see, e.g., FIG. 3 and the corresponding description above), or a modified lead frame capacitor (see, e.g., FIG. 4 and the corresponding description above). The form or type of the capacitor selected as part of block 914 may be based on the merits (e.g., benefits and drawbacks) of each form/type described above.

In block 918 ("Manufacture/Fabricate device and PCB (inclusive of capacitor"), the PCB and the packaged electronic device may be manufactured or fabricated. When the capacitor is formed in or on the PCB (e.g., capacitors 240, 340, FIGs 2, 3), the manufacture or fabrication of the PCB may include a manufacture or fabrication of a capacitor of the type/form identified/selected in block 914. When the capacitor is formed as part of the leadframe of a device (e.g., capacitor 440, FIG. 4), the manufacture or fabrication of the device (e.g., device 420, FIG. 4) may include a manufacture or fabrication of a capacitor of the type/form identified/selected in block 914. The manufacture or fabrication of the amplifier may include placing/depositing other components (e.g., transistors) onto the PCB.

It is understood and appreciated that aspects of some of the operations/blocks shown and described above in relation to FIG. 9 may be optional in some embodiments. Further, in some embodiments additional operations/blocks not shown may be included. Still further, the order or sequence of the operations/blocks may be different from what is explicitly shown in FIG. 9.

As set forth above, aspects and embodiments of the disclosure may be utilized in respect of various practical applications. For example, aspects of this disclosure may be utilized in respect of multiple-path power amplifiers (e.g., Doherty power amplifiers), signal conditioners (e.g., filters), IC or chip packages with various leads or wire topologies, PCBs, designs using GaN, Si-LDMOS, and other semiconductor technologies, etc., or various combinations thereof.

While some of the embodiments described herein pertain to a use of a capacitor to facilitate compensating for coupling (e.g., parasitic or inductive coupling), in some instances other types or kinds of components (potentially in lieu of, or in addition to, a capacitor) may be utilized. More generally, an impedance network may be utilized to realize an electromagnetic profile that may serve to compensate for one or more electromagnetic conditions.

In terms of embodiments utilizing a capacitor, it has been determined that a capacitor having a value of approximately 0.9 pF (e.g., 0.9 pF plus-or-minus X%, where X may be equal to one, two, three, .... ten) between a first transistor (e.g., carrier transistor 136, FIG. 1) and a second transistor (e.g., peaking transistor 156, FIG. 1) serves sufficiently well for reducing the impact of coupling between leads/wires (e.g., between bondwires 433, 453 or bondwires 446, 447, FIG. 4) for most operating frequencies of interest (e.g., 1 megahertz (MHz) to 3.5 gigahertz (GHz), inclusive) in accordance with the configurations shown in FIGS. 2 and 3. For the configuration shown in FIG. 4, the same or a different value of the capacitor (e.g., 0.7 pF plus-or-minus X%) may be used for most operating frequencies of interest. Of course, the values that are actually used in a given embodiment may be different. In this regard, in some embodiments the capacitor value that is utilized may be within a range from 0.5 pF to 1.5 pF, inclusive.

Aspects of this disclosure may readily lend themselves to conventional circuit, device, and PCB manufacturing/fabrication techniques. For example, aspects of this disclosure may be implemented with little-to-no additional cost (in terms of, e.g., package development or innovation) or energy consumption/power dissipation relative to conventional techniques, while at the same time providing additional benefits in terms of achieving/realizing isolation. In this respect, aspects of this disclosure represent substantial improvements relative to conventional technologies in terms of practical applications involving circuit design and assembly/fabrication/manufacture. In brief, and as demonstrated herein, the various aspects of this disclosure are not directed to abstract ideas. To the contrary, the various aspects of this disclosure are directed to, and encompass, significantly more than any abstract idea standing alone.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure, as defined by the claims. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. An amplifier circuit comprising:
a first amplifier path that includes a first input, a first transistor, and a first wire coupled between the first input and a first terminal of the first transistor;
a second amplifier path that includes a second input, a second transistor, and a second wire coupled between the second input and a first terminal of the second transistor; and
a planar capacitor with a first terminal coupled to the first input and a second terminal coupled to the second input, wherein the planar capacitor is configured to compensate for a coupling between the first wire and the second wire.

2. The amplifier circuit of claim 1, wherein the planar capacitor is formed from interdigitated pattern portions of a first conductive layer of a substrate.

3. The amplifier circuit of claim 2, wherein the planar capacitor includes a first set of capacitor fingers that are connected to a first mounting pad and a second set of capacitor fingers that are connected to a second mounting pad and interdigitated with the first set of capacitor fingers, wherein the first mounting pad is coupled to the first input, and the second mounting pad is coupled to the second input.

4. The amplifier circuit of claim 3, wherein the first mounting pad and the second mounting pad are located on a second conductive layer of the substrate that is different from the first conductive layer, and wherein the planar capacitor is connected to the first mounting pad and the second mounting pad with conductive vias.

5. The amplifier circuit of claim 3, wherein the first mounting pad and the second mounting pad are located on the first conductive layer.

6. The amplifier circuit of any preceding claim, wherein the amplifier circuit is included as part of a device, wherein the device includes a leadframe, and wherein the planar capacitor is included as a first portion of the leadframe.

7. The amplifier circuit of claim 6, wherein a second portion of the leadframe includes a first input terminal and a second input terminal.

8. The amplifier circuit of claim 7, wherein the planar capacitor includes a first set of capacitor fingers that are connected to the first input terminal and a second set of capacitor fingers that are connected to the second input terminal and interdigitated with the first set of capacitor fingers.

9. The amplifier circuit of claim 7 or 8, wherein the planar capacitor, the first input terminal, and the second input terminal are formed from a planar conductive sheet of material.

10. The amplifier circuit of any preceding claim, wherein the planar capacitor has a value within a range of 0.5 picofarads (pF) to 1.5 pF, inclusive.

11. The amplifier circuit of claim 1, wherein the amplifier circuit is a power amplifier selected from a Doherty power amplifier, a push-pull amplifier, a balanced amplifier, and a 2-up power amplifier.

12. A circuit comprising:
a radio frequency (RF) input node;
a RF output node;
a power splitter configured to split an input RF signal received at the RF input node and divide power of the input RF signal into a carrier portion of the input RF signal and a peaking portion of the input RF signal, wherein the carrier portion traverses a first path that includes a first transistor and the peaking portion traverses a second path that includes a second transistor; and
a first capacitor with a first terminal coupled to the first path and a second terminal coupled to the second path, the first capacitor compensating for parasitic coupling between first wirebonds of the first path and second wirebonds of the second path.

13. The circuit of claim 12, wherein the first capacitor is disposed between the power splitter and each of the first transistor and the second transistor.

14. The circuit of claim 12 or 13, wherein the first capacitor, the first transistor, the second transistor, the first wirebonds, and the second wirebonds are included in a device, the device being mounted on a substrate.

15. The circuit of any of claims 12 to 14, wherein the circuit is a power amplifier selected from a Doherty power amplifier, a push-pull amplifier, a balanced amplifier, and a 2-up power amplifier.

## Amended claims

### Amended claims in accordance with Rule 137(2) EPC.

1. A device comprising:
(a) an amplifier circuit comprising:
a first amplifier path (130) that includes a first input (121), a first transistor (136), and a first wire coupled between the first input and a first terminal (137) of the first transistor; and
a second amplifier path (150) that includes a second input (122), a second transistor (156), and a second wire coupled between the second input and a first terminal (157) of the second transistor; and
(b) a planar capacitor (140), having a first terminal coupled to the first input and a second terminal coupled to the second input;
wherein the planar capacitor is configured to compensate for a coupling between the first wire and the second wire;
wherein the planar capacitor includes a first set of capacitor fingers (510) and a second set of capacitor fingers (520) that are interdigitated with the first set of capacitor fingers; and
wherein either: the planar capacitor is formed from interdigitated pattern portions of a first conductive layer of a substrate (201) included in the device; or the planar capacitor is included as a first portion of a leadframe included in the device.

2. The amplifier circuit of claim1 in which the planar capacitor is formed from interdigitated pattern portions of a first conductive layer of a substrate, wherein the first set of capacitor fingers are connected to a first mounting pad (261) and the second set of capacitor fingers are connected to a second mounting pad (262), wherein the first mounting pad is coupled to the first input (121), and the second mounting pad is coupled to the second input (122).

3. The amplifier circuit of claim 2, wherein the first mounting pad and the second mounting pad are located on a second conductive layer of the substrate that is different from the first conductive layer, and wherein the planar capacitor is connected to the first mounting pad and the second mounting pad with conductive vias.

4. The amplifier circuit of claim 2, wherein the first mounting pad and the second mounting pad are located on the first conductive layer.

5. The amplifier circuit of claim 1 in which the planar capacitor is included as a first portion of the leadframe, wherein a second portion of the leadframe includes a first input terminal and a second input terminal.

6. The amplifier circuit of claim 5, wherein the planar capacitor includes a first set of capacitor fingers that are connected to the first input terminal and a second set of capacitor fingers that are connected to the second input terminal and interdigitated with the first set of capacitor fingers.

7. The amplifier circuit of claim 5 or 6, wherein the planar capacitor, the first input terminal, and the second input terminal are formed from a planar conductive sheet of material.

8. The amplifier circuit of any preceding claim, wherein the planar capacitor has a value within a range of 0.5 picofarads (pF) to 1.5 pF, inclusive.

9. The amplifier circuit of any preceding claim, wherein the amplifier circuit is a power amplifier selected from a Doherty power amplifier, a push-pull amplifier, a balanced amplifier, and a 2-up power amplifier.

10. The device according to any preceding claim, further comprising:
a radio frequency, RF, input node;
a RF output node;
a power splitter configured to split an input RF signal received at the RF input node and divide power of the input RF signal into a carrier portion of the input RF signal and a peaking portion of the input RF signal, wherein the carrier portion traverses the first path that includes the first transistor and the peaking portion traverses the second path that includes the second transistor;
wherein the first capacitor is for compensating for parasitic coupling between first wirebonds of the first path and second wirebonds of the second path, wherein the first wirebonds comprise the first wire and the second wirebonds comprise the second wire.

11. The device of claim 10, wherein the first capacitor is disposed between the power splitter and each of the first transistor and the second transistor.
